# EUROPÄISCHE PATENTSCHRIFT

(11) **EP 4 573 042 B1**
(45) Veröffentlichungstag und Bekanntmachung des Hinweises auf die Patenterteilung: **18.11.2026**
(21) Anmeldenummer: 23739563.7
(22) Anmeldetag: 10.07.2023
(51) Int. Cl.: B81C 1/00

(54) **VERFAHREN ZUR HERSTELLUNG EINES SILIZIUMSCHICHTSYSTEMS MIT ELEKTRISCHEN VERBINDUNGEN**
METHOD FOR PRODUCING A SILICON LAYER SYSTEM WITH ELECTRICAL CONNECTIONS
PROCÉDÉ DE PRODUCTION D'UN SYSTÈME DE COUCHES DE SILICIUM AYANT DES CONNEXIONS ÉLECTRIQUES

(30) Priorität: 17.08.2022 DE 102022208515
(43) Veröffentlichungstag der Anmeldung: 25.06.2025
(73) Patentinhaber: Robert Bosch GmbH, 70442 Stuttgart (DE)
(72) Erfinder: KAELBERER, Arnd, 73278 Schlierbach (DE); TOMASCHKO, Jochen, 71126 Gaeufelden (DE); KUEPPERS, Hartmut, 72762 Reutlingen (DE); STAHL, Heiko, 72760 Reutlingen (DE); HARZHEIM, Achim, 72076 Tuebingen (DE)
(86) Internationale Anmeldenummer: PCT/EP2023/068975
(87) Internationale Veröffentlichungsnummer: WO 2024/037787

(56) Entgegenhaltungen:
- DE-T5- 112013 004 119
- CHEN YUNHAN ET AL: "Robust Method of Fabricating Epitaxially Encapsulated MEMS Devices with Large Gaps", JOURNAL OF MICROELECTROMECHANICAL SYSTEMS., vol. 26, no. 6, 1 December 2017 (2017-12-01), US, pages 1235 - 1243, XP093091625, ISSN: 1057-7157, DOI: 10.1109/JMEMS.2017.2758388

## Beschreibung

### Verbindungen

Die vorliegende Erfindung bezieht sich auf das Gebiet der Siliziumschichtsysteme und betrifft ein Verfahren zur Herstellung eines Siliziumschichtsystems mit elektrischen Verbindungen. Des Weiteren betrifft sie ein Siliziumschichtsystem und eine mikroelektromechanische Vorrichtung mit einem solchen Siliziumschichtsystem.

### Stand der Technik

Aus der DE 10 2015 206 996 A1 ist der sogenannte EPyC-Prozess (EPyC: epitaxial polysilicon cycle) zum Herstellen von mikroelektromechanischen Strukturen mit großer vertikaler Ausdehnung bekannt, der epitaktisches Polysilizium als Funktions- und Opfermaterial nutzt und mittels sich wiederholender Zyklen eine Schichtstruktur aus epitaktischen Polysiliziumschichten aufbaut. Die Dokumente US 2014/0117469 A1 und US 2018/0111823 A1 beschäftigen sich mit der Kombination von MEMS (microelectromechanical system) mit TSVs (TSV: through-silicon via).

Die Dokumente DE 11 2013 004119 T5 und "Robust Method of Fabricating epitaxially encapsulated MEMS devices with large caps" von Chen Yunhan et al. beschreiben teilweise Merkmale des Verfahrens zur Herstellung eines Siliziumschichtsystems mit elektrischen Verbindungen gemäß Anspruch 1. DE 11 2013 004119 T5 offenbart ein Schichtsystem mit einer alternierenden Abfolge von strukturierten Siliziumschichten mit Funktionsbereichen und strukturierten Passivierungsschichten. Vergrabene Siliziumschichten sind durch verfüllte Gräben kontaktiert.

### Offenbarung der Erfindung

Erfindungsgemäß werden ein Verfahren zur Herstellung eines Siliziumschichtsystems mit elektrischen Verbindungen, ein entsprechendes Siliziumschichtsystem sowie eine mikroelektromechanische Vorrichtung mit einem solchen Siliziumschichtsystem vorgeschlagen.

Gemäß eines ersten Aspekts der Erfindung wird ein Verfahren zur Herstellung eines Siliziumschichtsystems mit elektrischen Verbindungen vorgeschlagen, das beispielsweise Strukturen für eine mikroelektromechanische Vorrichtung wie ein MEMS (microelectromechanical system) umfassen kann. Das Verfahren beinhaltet dabei ein Bereitstellen eines Trägersubstrats, das beispielsweise im Wesentlichen aus Silizium bestehen kann. Auf einer Oberfläche des Trägersubstrats ist eine Isolationsschicht ausgebildet, wobei die Isolationsschicht selbst nicht Teil des Trägersubstrats ist. Eine solche Isolationsschicht dient zur elektrischen und mechanischen Isolation zwischen Substrat und der Siliziumschicht des folgenden ersten EPyC-Zyklus.

Bei der Isolationsschicht handelt es sich vorzugsweise um eine Siliziumoxid- und/oder Siliziumnitridschicht. Die Isolationsschicht dient vorzugsweise als Ätzstoppschicht für ein späteres Siliziumopferschichtätzen. Durch Verwendung einer solchen Ätzstoppschicht kann auf aufwendige und stark schwankende zeitabhängige Ätzverfahren verzichtet werden. Insbesondere zum Herstellen von elektrischen Verbindungen durch die Isolationsschicht hindurch kann die Isolationsschicht strukturiert sein und/oder vor Durchführung der weiteren Schritte strukturiert werden.

Auf die Isolationsschicht wird eine erste Siliziumschicht aufgebracht, beispielsweise gebondet, aufgesputtert und/oder bevorzugt aufgewachsen, insbesondere epitaktisch aufgewachsen. Hierbei erfolgt ein epitaktisches Aufwachsen insbesondere bei Temperaturen von typischerweise > 600 °C, vorzugsweise > 900 °C. Eine Strukturierung der Isolationsschicht kann vor diesem Aufbringen der ersten Siliziumschicht erfolgen und/oder nach einem Entfernen des Trägersubstrats, also von der entgegengesetzten Seite. Die aufgebrachte erste Siliziumschicht kann beispielsweise eine einkristalline, eine polykristalline und/oder eine epi-polykristalline Siliziumschicht umfassen oder sein. Als epi-polykristalline Siliziumschichten werden hierbei polykristalline Siliziumschichten bezeichnet, die epitakisch aufgewachsen worden sind, also unter epitaktischen Wachstumsbedingungen Solche epi-polykristallinen Siliziumschichten besitzen typischerweise Dicken von mehr als 5 µm, häufig auch von mehreren 10 µm.

Ein epitaktisches Aufwachsen auf die Isolationsschicht, beispielsweise einer Siliziumoxidschicht, kann das vorherige Aufbringen einer Polysilizium-Startschicht, beispielsweise mittels CVD-Polysiliziumabscheidung (CVD: chemical vapour deposition, Chemische Gasphasenabscheidung), auf die Isolationsschicht umfassen, da Polysilizium (polykristallines Silizium) typischerweise nicht direkt auf der Isolationsschicht epitaxiert werden kann. Dies gilt ebenfalls für die weiter unten diskutierten Passivierungsschichten. Bereiche, die nicht durch die Isolationsschicht oder eine Passivierungsschicht bedeckt werden, können durch eine CVD-Polysiliziumabscheidung befüllt werden, wodurch ein elektrischer Kontakt zu einer anschließend aufzuwachsenden Siliziumschicht hergestellt wird. Es wird also eine Verdrahtungsschicht ausgeprägt. Eine direkte Epitaxierung ohne eine Polysilizium-Startschicht kann allerdings auch dadurch möglich gemacht werden, indem eine Prozessführung gewählt wird, bei der sich von selbst Kristallisationskeime bilden. Der Begriff des epitaktischen Aufwachsens bezeichnet im Rahmen dieser Erfindung beide möglichen Varianten, also das indirekte epitaktische Aufwachsen unter Verwendung einer vorher zumindest teilweise aufzubringenden Startschicht und ein direktes epitaktisches Aufwachsen ohne Startschicht.

Ein Trägersubstrat mit einer auf eine Isolationsschicht aufgebrachten Siliziumschicht kann auch direkt in Form eines Rohwafers wie eines SOI-Wafers (SOI: Silicon-on-Insulator) zur Verfügung gestellt werden. Eine Schichtdicke der ersten Siliziumschicht und auch von weiteren aufgebrachten Siliziumschichten kann beispielsweise 0,5 bis 100 µm, vorzugsweise 20 bis 60 µm betragen.

Diese erste Siliziumschicht wird zum Ausbilden von Gräben in der ersten Siliziumschicht strukturiert, wobei sich die Gräben zumindest stellenweise durch die erste Siliziumschicht erstrecken. Eine solche Strukturierung kann beispielsweise mittels eines reaktiven Ionenätzens (RIE, reactive ion etching) und/oder eines reaktiven lonentiefätzens (DRIE, deep reactive-ion etching) und/oder, insbesondere im Fall von relativ dünnen Siliziumschichten, mittels eines Plasmaätzverfahrens erfolgen.

Die erste Siliziumschicht wird anschließend passiviert, wobei die Gräben befüllt werden und sich auf einer der Isolationsschicht abgewandten Seite der ersten Siliziumschicht eine erste Passivierungsschicht bildet. Die Befüllung der Gräben erfolgt hierbei durch das Ausbilden der ersten Passivierungsschicht in den Gräben. Vorzugsweise bedeckt die Passivierungsschicht im Wesentlichen die gesamte Oberfläche der ersten Siliziumschicht einschließlich der Gräben. Für die Passivierung können Passivierungstechniken wie beispielsweise thermische Oxidation und/oder Tetraethylorthosilicat-Abscheidung (TEOS-Abscheidung), Siliziumcarbid-Abscheidung (SiC-Abscheidung), Siliziumcarbonitrid-Abscheidung (SiCN-Abscheidung), Siliziumnitrid-Abscheidung (SiₓN_{y}-Abscheidung) oder Siliziumoxynitrid-Abscheidung (SiON-Abscheidung) angewendet werden. Bereiche der Siliziumschicht, welche nicht geätzt werden sollen, werden durch die Passivierungsschicht vor einem Ätzangriff geschützt. Die Bereiche der Siliziumschicht mit Zugang für ein zum Ätzen verwendetes Ätzmedium (Opferbereiche) können vollständig geätzt werden. Die Passivierungsschicht dient also als lateraler und vertikaler Ätzstopp, kann also dies betreffend eine der Isolationsschicht identische Funktion haben. Die erzeugten Passivierungsschichten können abhängig von der verwendeten Passivierungstechnik aus unterschiedlichen Materialien bestehen, beispielsweise aus Siliziumoxid und/oder Siliziumnitrid. Beispielsweise kann so mit einem Verfahren zur Oxidätzung die Teile der Passivierungsschichten erhalten bleiben, die aus Siliziumnitrid bestehen, das dann zur elektrischen Isolation im Betrieb des durch das Verfahren erzeugten Schichtsystems dienen kann.

Die so gebildete erste Passivierungsschicht wird strukturiert, wobei sich durch diese Strukturierung in der ersten Siliziumschicht erste Opferbereiche und Funktionsbereiche ausbilden und die ersten Opferbereiche auf der der Isolationsschicht abgewandten Seite der ersten Siliziumschicht zumindest stellenweise frei von der ersten Passivierungsschicht sind.

Nach dem Strukturieren der ersten Passivierungsschicht werden die Schritte des Aufbringens, beispielsweise des epitaktischen Aufwachsens, des Strukturierens und des Passivierens der ersten Siliziumschicht, wie sie oben beschrieben sind, jeweils wiederholt. Auch wird das Strukturieren der ersten Passivierungsschicht wie oben beschrieben wiederholt. Eine solche Wiederholung kann mehrmals, beispielsweise zweimal, dreimal, fünfmal oder zehnmal, geschehen. Im Rahmen einer solcher Wiederholung erfolgt das Aufbringen jeweils auf eine strukturierte Passivierungsschicht (nämlich der gerade zuäußerst liegenden) anstatt der Isolationsschicht. Hierdurch werden weitere Siliziumschichten und weitere Passivierungsschichten ausgebildet und strukturiert. Es entstehen durch das Ausbilden und Strukturieren der weiteren Siliziumschichten und der weiteren Passivierungsschichten weitere Opferbereiche und weitere Funktionsbereiche in den weiteren Siliziumschichten. Gleichzeitig können durch die Strukturierung der weiteren Passivierungsschichten elektrische Verbindungen und Isolationen zwischen bestimmten Bereichen der Siliziumschichten erreicht werden. Die aufeinander gestapelten Schichten können hierbei genau gegeneinander justiert werden. Jede Siliziumschicht kann unabhängig von anderen Siliziumschichten strukturiert und gestaltet werden. Insbesondere sind auch ineinander verzahnte und/oder sich überlappende Funktionsbereiche, insbesondere hinsichtlich einer vertikalen Ausdehnung, möglich. Das Verfahren ermöglicht es auch, elektrische Verbindungen und Isolationen und mechanische Verbindungen und Isolationen innerhalb der Funktionsbereiche frei zu gestalten. Im Rahmen dieses Vorgehens können vor dem Aufbringen der nächsten Siliziumschicht solche Bereiche, die frei von einer Passivierungsschicht sind, mittels CVD-Polysiliziumabscheidung befüllt werden, um eine Verdrahtungsschicht auszuprägen. Auch kann durch eine solche CVD-Polysiliziumabscheidung eine Startschicht im Rahmen des Schritts des Aufbringens der nächsten Siliziumschicht generiert werden.

Hierbei erfolgen die Schritte des Aufbringens, des Strukturierens und des Passivierens der Siliziumschichten einschließlich der ersten Siliziumschicht und ebenso des das Strukturierens der Passivierungsschichten einschließlich der ersten Passivierungsschicht so, dass hierbei eine elektrische Verbindung innerhalb des sich bildenden Siliziumschichtsystems mindestens einen spezialisierten Funktionsbereich ausgeprägt wird, wobei durch diese elektrische Verbindung ein elektrischer Kontakt zwischen zwei Elementen innerhalb und/oder außerhalb des Siliziumschichtsystems herstellbar ist, wobei weiterhin der mindestens eine spezialisierte Funktionsbereich allein der elektrischen Verbindung dient. Ein spezialisierter Funktionsbereich ist hierbei ein durch die Verfahrensschritte ausgebildeter Funktionsbereich. Eine so ausgeprägte elektrische Verbindung kann vollständig aus allein der elektrischen Verbindung dienenden spezialisierten Funktionsbereichen bestehen. Bei den zwei Elementen kann es sich um interne und/oder externe Elemente handeln. Bei internen Elementen kann es sich beispielsweise um Funktionsbereiche handeln, die nicht auf die elektrische Stromführung spezialisiert sind, also die zum Beispiel Teil einer Elektrode, eines Aktors und/oder eines Sensors sein können oder selbst sind. Bei einem externen Element kann es sich beispielsweise um eine externe Strom- und/oder Signalquelle, zum Beispiel eine Steuerelektronik, handeln mit einer externen elektrischen Verbindung, beispielsweise einem Draht oder einem Lötkontakt handeln, die mit dem Siliziumschichtsystem verbunden ist. Auch eine solche externe elektrische Verbindung selbst, wie ein Draht oder ein Lötkontakt, stellt ein externes Element dar. Bei den Elementen handelt es sich also generell um elektrische Funktionselemente. Abschließend werden alle Opferbereiche entfernt, typischerweise mittels eines Ätzverfahrens (Siliziumopferschichtätzen).

Erfindungsgemäß wird also ein Verfahren zum Ausbilden von elektrischen Verbindungen in einem beliebig ausgedehnten Siliziumschichtsystem vorgeschlagen. Dieses Verfahren nutzt erfindungsgemäß den EPyC-Prozess. Für weitere Details bezüglich des EPyC-Prozesses sei auf die DE 10 2015 206 996 A1 verwiesen, die hiermit vollständig als Bestandteil der vorliegenden Anmeldung in diese integriert ist.

In einer bevorzugten Ausführungsform des erfindungsgemäßen Verfahrens ist die elektrische Verbindung eine vertikal (senkrecht zu der Oberfläche des Trägersubstrats) verlaufende elektrische Verbindung oder umfasst eine solche, wobei die vertikal verlaufenden elektrische Verbindung aus mehreren übereinander angeordneten spezialisierten Funktionsbereichen der Funktionsbereiche besteht oder diese umfasst, wobei die mehreren spezialisierten Funktionsbereiche allein der elektrischen Verbindung dienen. Auch kann die elektrische Verbindung eine horizontal verlaufende elektrische Verbindung sein oder diese umfassen.

Die Angaben vertikal und horizontal sind hierbei in Bezug auf die Oberfläche des Trägersubstrats zu verstehen, die mit der Isolationsschicht versehen ist. Eine horizontal verlaufende elektrische Verbindung ist eine elektrische Verbindung, die dazu dient, Strom horizontal zu leiten in dem Sinne, dass die Richtung des Stroms (Stromrichtung) von einer im Wesentlichen vertikalen Richtung abweicht, also beispielsweise parallel oder schräg zur Oberfläche des Trägersubstrats verläuft. Eine solche horizontale verlaufende elektrische Verbindung umfasst folglich einen auf die elektrische Stromleitung spezialisierten Funktionsbereich, der in elektrischem Kontakt zu anderen Funktionsbereichen oder anderen Elementen innerhalb und/oder außerhalb des Siliziumschichtsystems steht, wobei diese elektrischen Kontakte nicht vertikal übereinander angeordnet sind, sondern seitlich versetzt zueinander. Insbesondere kann ein Funktionsbereich, der Teil einer horizontal verlaufenden elektrischen Verbindung ist, auch Teil einer vertikal verlaufenden elektrischen Verbindung sein, beispielsweise wenn dieser Funktionsbereich drei oder mehr elektrische Kontakte zu umliegenden weiteren Funktionsbereichen aufweist, wenn zwei dieser elektrischen Kontakte vertikal zueinander angeordnet sind und der dritte seitlich versetzt zu den beiden anderen.

Bevorzugt erfolgt nach dem Entfernen aller Opferbereiche auch ein zumindest stellenweises Entfernen der ersten Passivierungsschicht und/oder einer oder mehrerer der weiteren Passivierungsschichten, gegebenenfalls einschließlich einem Freilegen von Gräben und/oder der Isolationsschicht, beispielsweise um eine gewünschte Beweglichkeit der erzeugten Strukturen herzustellen. Dies ist insbesondere dann vorteilhaft, wenn durch das erfindungsgemäße Verfahren die Funktionsbereiche vorteilhaft zueinander vollständig fixiert sind. Es können beispielsweise Ausnehmungen und/oder Aussparungen in einer der erzeugten Passivierungsschichten geschaffen werden und/oder eine Freilegung von Gräben erfolgen. Die Passivierungsschicht kann auch vollständig entfernt werden. Dies kann die Freilegung der Gräben einschließen. Beispielsweise kann das Entfernen der Passivierungsschicht oder Teilen dieser durch ein Gasphasenätzen, ein Plasmaätzen und/oder ein Nassätzen erfolgen. Die Passivierungsschicht oder Teile von dieser können hiermit besonders einfach entfernt werden.

Die erzeugten Passivierungsschichten können abhängig von der verwendeten Passivierungstechnik aus unterschiedlichen Materialien bestehen, beispielsweise aus Siliziumoxid und/oder Siliziumnitrid. Gemäß einer bevorzugten Ausführungsform des Verfahrens ist es besonders vorteilhaft, wenn eine der Passivierungsschichten zumindest stellenweise aus einem ersten Material und eine der Passivierungsschichten und/oder die Isolationsschicht zumindest stellenweise aus einem zweiten Material gebildet wird. Um dies zu erreichen können zwei verschiedene Passivierungstechniken für das Passivieren der Siliziumschichten eingesetzt werden, so dass die Passivierungsschichten oder Bereiche der Passivierungsschichten aus zwei verschiedenen Materialiengebildet werden. Beispielsweise können als eine erste Passivierungstechnik thermische Oxidation und/oder TEOS-Abscheidung verwendet werden und als eine zweite Passivierungstechnik Siliziumnitrid-Abscheidung, wodurch Passivierungsschichten gebildet werden können, von denen ein erster Teil aus Siliziumoxid und ein zweiter Teil aus Siliziumnitrid besteht. Hierbei eingeschlossen ist die Möglichkeit, dass Passivierungsschichten auch stellenweise aus Siliziumoxid und stellenweise aus Siliziumnitrid bestehen. Diese Ausführungsform des erfindungsgemäßen Verfahrens ermöglicht es, bei entsprechender Wahl eines Verfahrens zur Entfernung der Teile der Passivierungsschichten aus dem ersten Material, beispielsweise Siliziumoxid, den Teil der Passivierungsschichten stehen zu lassen, der aus dem zweiten Material, beispielsweise Siliziumnitrid, besteht. Hiermit kann gezielt und auf einfache Art und Weise die elektrische Isolation zwischen verschiedenen Funktionsbereichen sichergestellt werden, da es sich sowohl bei Siliziumoxid als auch Siliziumnitrid um Dielektrika handelt. Beispielsweise kann mit einem Verfahren zur Oxidätzung die Teile der Passivierungsschichten erhalten bleiben, die aus Siliziumnitrid bestehen, das dann zur elektrischen Isolation im Betrieb des durch das Verfahren erzeugten Schichtsystems dienen kann.

In einer vorteilhaften Ausgestaltung des erfindungsgemäßen Verfahrens erfolgt weiterhin ein Entfernen des Trägersubstrats. Hierdurch kann das erzeugte Schichtsystem unabhängig vom Trägersubstrat weiterverwendet werden. Vorzugsweise erfolgt ein solches Entfernen vor einem Entfernen aller verbliebenen Opferbereiche (typischerweise mittels eines Siliziumopferschichtätzens). Ein Entfernen des Trägersubstrats erfolgt vorzugsweise mittels eines chemisch-mechanischen Polierens (CMP).

Bevorzugt umfasst mindestens eine der aufgebrachten Siliziumschichten, beispielsweise die erste Siliziumschicht und/oder eine der weiteren Siliziumschichten, eine einkristalline, eine polykristalline und/oder eine epi-polykristalline Siliziumschicht oder ist eine solche. Weiterhin kann eine Schichtdicke mindestens einer der aufgebrachten Siliziumschichten, beispielsweise der ersten Siliziumschicht und/oder der zweiten Siliziumschicht und/oder einer der weiteren Siliziumschichten, beispielsweise 0,5 bis 100 µm betragen, vorzugsweise 20 bis 60 µm. Dünne Siliziumschichten eignen sich bei MEMS beispielsweise als federnde Elemente für vertikale Auslenkungen. Dicke Siliziumschichten hingegen sind vorteilhaft zur Herstellung von Elektrodenkämmen oder auch, um große Volumen zu füllen beziehungsweise als Opferbereiche auch wieder zu entfernen.

Vorzugsweise erfolgt das Strukturieren zum Ausbilden der Gräben mittels eines Trench-Prozesses wie reaktivem Ionenätzen (RIE, reactive ion etching) und/oder reaktivem lonentiefätzen (DRIE, deep reactive-ion etching) und/oder mittels eines Plasmaätzverfahrens. Hierbei ist ein Plasmaätzverfahren insbesondere bei dünnen Schichten (Dicken von wenigen Mikrometern) sinnvoll. Für dickere Schichten kann beispielsweise DRIE verwendet werden.

Gemäß einer bevorzugten Ausgestaltung des erfindungsgemäßen Verfahrens erfolgt das Strukturieren der Passivierungsschichten durch ein Trockenätzverfahren und/oder ein Nassätzverfahren. Die Passivierungsschichten können also einfach wieder entfernt werden, ohne auf ein spezifisches Ätzverfahren zurückgreifen zu müssen.

Weiterhin ist es vorteilhaft, wenn nach dem Aufbringen einer der Siliziumschichten ein chemisch-mechanisches Polieren (CMP) und/oder zumindest stellenweise eine zusätzliche Dotierung durch Implantation und/oder Belegung dieser Siliziumschicht erfolgt. Somit können insbesondere im Fall eines epitaktischen Aufwachsens der Siliziumschicht entstehende topologische Unregelmäßigkeiten und Höhenunterschiede auf einfache Art und Weise planarisiert werden. Durch die zusätzliche Dotierung durch Implantation oder Belegung kann auf einfache Art und Weise eine gewünschte Leitfähigkeit in der Siliziumschicht oder in bestimmten Bereichen dieser eingestellt werden. Die aufgewachsenen Siliziumschichten können undotiert, p-dotiert oder n-dotiert sein. Ein solches Vorgehen ist besonders geeignet, um eine besonders gute Leitfähigkeit der spezialisierten Funktionsbereiche der auszuprägenden elektrischen Verbindung zu erreichen.

Bevorzugt erfolgt das Entfernen von Opferbereichen zumindest teilweise durch plasmaloses und/oder plasmaunterstütztes Ätzen, also mittels Verfahren zum Siliziumopferschichtätzen. Somit können die Opferbereiche besonders einfach entfernt werden. Ein solches plasmalose Ätzen kann beispielsweise durch Chlortrifluorid (ClF₃), Chlorfluorid (ClF), Chlorpentafluorid (ClF₅), Bromtrifluorid (BrF₃), Brompentafluorid (BrF₅), Jodpentafluorid (IF₅), Jodheptfluorid (IF₇), Schwefeltetrafluorid (SF₄), Xenondifluorid (XeF₂) oder ähnliche Substanzen erfolgen. Das plasmaunterstützte Ätzen kann beispielsweise durch Fluorplasma, Chlorplasma und/oder Bromplasma erfolgen. Insbesondere kann das Ätzen auch auf einer Kombination aus plasmalosem und plasmaunterstütztem Ätzen basieren.

Gemäß eines zweiten Aspekts der Erfindung wird ein Siliziumschichtsystem vorgeschlagen, das vorzugsweise unter Verwendung eines erfindungsgemäßen Verfahrens hergestellt wurde. Das Siliziumschichtsystem weist eine alternierende Abfolge von strukturierten Siliziumschichten mit Funktionsbereichen und strukturierten Passivierungsschichten und eine elektrische Verbindung bestehend aus einem oder mehreren spezialisierten Funktionsbereichen der Funktionsbereiche auf. Hierbei ist durch die elektrische Verbindung ein elektrischer Kontakt zwischen zwei Elementen innerhalb und/oder außerhalb des Siliziumschichtsystems herstellbar, wobei der eine oder die mehreren spezialisierten Funktionsbereiche allein der elektrischen Verbindung dienen.

Bei einem solchen Schichtsystem kann die elektrische Verbindung eine vertikal verlaufende elektrische Verbindung sein oder umfassen, die aus mehreren übereinander angeordneten spezialisierten Funktionsbereichen der Funktionsbereiche besteht oder diese umfasst, wobei die mehreren spezialisierten Funktionsbereiche allein der elektrischen Verbindung dienen. Alternativ oder gleichzeitig kann die elektrische Verbindung auch eine horizontal verlaufende elektrische Verbindung sein oder umfassen.

Gemäß eines dritten Aspekts der Erfindung wird schließlich eine mikroelektromechanische Vorrichtung vorgeschlagen, die ein erfindungsgemäßes Siliziumschichtsystem umfasst.

### Vorteile der Erfindung

Das erfindungsgemäße Verfahren ermöglicht es, auf einfache Art und Weise ein Siliziumschichtsystem mit elektrischen Verbindungen, insbesondere TSVs (TSV: through-silicon via), auszugestalten. Ein bedeutender Vorteil des erfindungsgemäßen Verfahrens ist seine hohe Flexibilität und Variabilität.

Besonders vorteilhaft ist der Einsatz des Verfahrens deshalb bei der Erzeugung von mikroelektromechanischen Strukturen für mikroelektromechanische Vorrichtungen, da hier typischerweise eine hohe Variabilität des eingesetzten Verfahrens zur elektrischen Verschaltung hinsichtlich der Dimensionierung dieser Verschaltungen benötigt wird: Die Wahl der Dimensionen sowohl der elektrischen Verbindungen als auch der Isolationsstrukturen und die Führung dieser muss flexibel gewählt werden können. Dies wird durch das erfindungsgemäße Verfahren ermöglicht. Insbesondere eignet sich das Verfahren hierbei für Verkabelungsstrukturen und TSVs, die eine große horizontale und vertikale Ausdehnung aufweisen.

Hierbei kommt das Verfahren ohne aufwendige Zwischenschritte zur Platzierung von elektrischen Verbindungen aus. Insbesondere sind keine zusätzlichen Lithographie- und/oder Strukturierungsschritte erforderlich, wie insbesondere im Fall der Herstellung von separaten TSVs. Das Verfahren integriert die Herstellung des eigentlichen Siliziumschichtsystems, beispielsweise der mikroelektromechanischen Strukturen, mit dem Aufbau der elektrischen Verbindungen zwischen gewünschten Elementen. Der erfindungsgemäße Prozess ist weiterhin CMOS- und hochtemperaturtauglich und eignet sich damit insbesondere auch zur Massenproduktion, beispielsweise von MEMS. Insbesondere sind durch die hohe Temperaturtoleranz auch Eintreibschritte und Annealing unproblematisch.

### Kurze Beschreibung der Zeichnungen

Ausführungsformen der Erfindung werden anhand der Zeichnungen und der nachfolgenden Beschreibung näher erläutert.

Es zeigen:
- Figuren 1A und 1B: schematische Querschnittsansichten zur Erläuterung eines erfindungsgemäßen Verfahrens zur Herstellung eines Siliziumschichtsystems mit elektrischen Verbindungen;
- Figur 2: ein schematisches Flussdiagramm zur Erläuterung eines erfindungsgemäßen Verfahrens zur Herstellung eines Siliziumschichtsystems mit elektrischen Verbindungen; und
- Figur 3: eine schematische Darstellung einer beispielhaften erfindungsgemäßen mikroelektromechanischen Vorrichtung.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

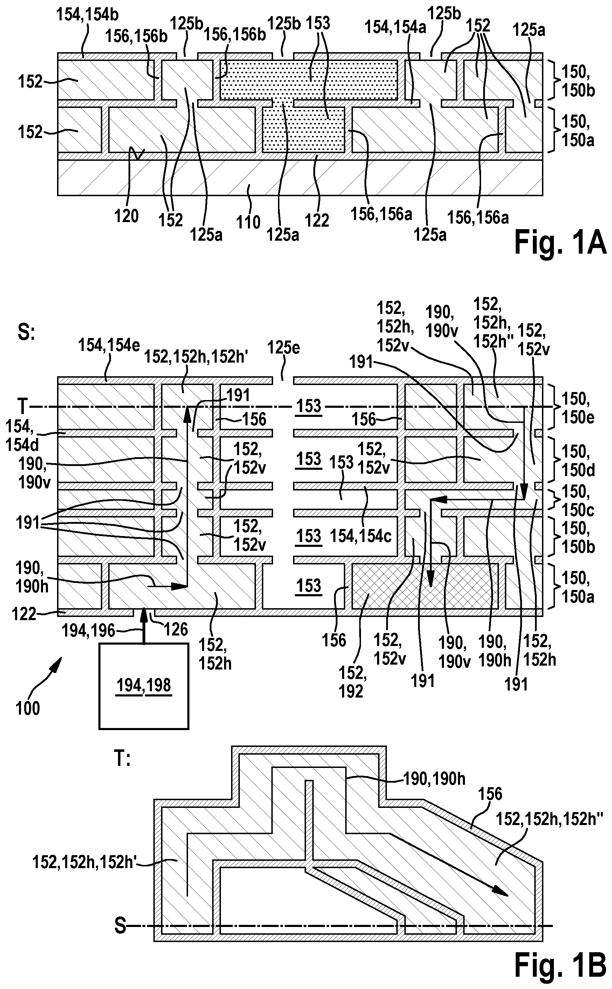

In den Figuren 1A und 1B werden schematische Querschnittsansichten zur Erläuterung eines beispielhaften erfindungsgemäßen Verfahrens zur Herstellung von mikroelektromechanischen Strukturen gezeigt. In den Figuren sind der besseren Übersicht halber Isolationsschichten und Passivierungsschichten (sowohl innerhalb und außerhalb der eingezeichneten Gräben) identisch dargestellt. Alle in den Figuren als zweidimensionale Objekte dargestellten Schichten besitzen auch eine dritte Raumdimension und können auch entlang dieser durch das erfindungsgemäße Verfahren strukturiert werden, was eine äußerst hohe Flexibilität ermöglicht.

Hierbei zeigt Figur 1A ein bereitgestelltes Trägersubstrat 110. Weiterhin ist eine Isolationsschicht 122, beispielsweise aus Siliziumoxid, gezeigt, die auf eine erste Oberfläche 120 des Trägersubstrats 110 aufgebracht wurde.

Auf der Isolationsschicht 122 wurde mittels eines erfindungsgemäßen Verfahrens eine erste Siliziumschicht 150a aufgebracht, beispielsweise epitaktisch aufgewachsen, und anschließend strukturiert. Hierbei wurden Gräben 156a ausgebildet, die sich durch die erste Siliziumschicht 150a erstrecken. Durch Passivieren der ersten Siliziumschicht 150a wurden die Gräben 156a befüllt, gleichzeitig wurde auch eine erste Passivierungsschicht 154a auf einer der Isolationsschicht 122 abgewandten Seite gebildet. Auch diese erste Passivierungsschicht 154a wurde strukturiert (Ausnehmungen 125a), wobei sich in der ersten Siliziumschicht 150a Funktionsbereiche 152 und Opferbereiche 153 ausbilden. Hierdurch wird erreicht, dass die Opferbereiche 153 hinterher durch einen Ätzprozess mit einem Ätzmedium entfernbar sind, wobei die Bereiche der Siliziumschichten 150 als Opferbereiche 153 agieren, die Zugang zum Ätzmedium haben. Diese Schritte des Aufbringens 220, des Strukturierens 230 und des Passivierens 240 der ersten Siliziumschicht 150a wurden anschließend noch ein weiteres Mal wiederholt. Hierbei wurde eine weitere Siliziumschicht 150b auf die erste Passivierungsschicht 154a aufgebracht, dabei wurden die Ausnehmungen 125a in der ersten Passivierungsschicht 154a befüllt. Diese weitere Siliziumschicht 150b wurde mittels weiterer Gräben 156b strukturiert. Durch eine Passivierung wurden diese Gräben 156b befüllt und auch außerhalb der Gräben 156b wurde eine weitere Passivierungsschicht 154b erzeugt. Die weitere Passivierungsschicht 154b wurden anschließend strukturiert (Ausnehmungen 125b). Beide aufgebrachten Siliziumschichten 150a, 150b sind hierbei mit einem gemeinsamen Bezugszeichen 150 gekennzeichnet, das gemeinsame Bezugszeichen 156 kennzeichnet die befüllten Gräben, das gemeinsame Bezugszeichen 154 die Passivierungsschichten außerhalb der Gräben.

Weitere Siliziumschichten 150 können aufgebracht, strukturiert und passiviert werden, wobei durch die Strukturierung der Passivierungsschichten 154 eine Definition der Funktionsbereiche 152 und der Opferbereiche 153 erfolgt. Gezeigt sind in Figur 1B das durch das erfindungsgemäße Verfahren hergestellte Siliziumschichtsystem 100 mit einer elektrischen Verbindung 190, wobei im Vergleich zu Figur 1A drei weitere aufgebrachte und strukturierte Siliziumschichten 150c, 150d, 150e mit Gräben 156 sowie entsprechend drei weitere strukturierte Passivierungsschichten 154c, 154d, 154e dargestellt sind.

Schließlich wurde in Figur 1B das Trägersubstrat 110 entfernt, die erzeugten Strukturen können nun vollständig freigestellt werden, indem die Opferbereiche 153 beispielsweise mittels plasmalosen und/oder plasmaunterstütztem Ätzen entfernt werden. Die Bereiche der Siliziumschichten 150, die Zugang zu dem bei diesem Ätzvorgang verwendeten Ätzmedium haben, beispielsweise über die Ausnehmung 125e der Passivierungsschicht 154e, also die Opferbereiche 153, werden vollständig geätzt. Je nach Erfordernis kann abschließend ein zumindest teilweises Entfernen der Passivierungsschichten 154 einschließlich einem Freilegen der Gräben 156 und/oder der Isolationsschicht 122 erfolgen (nicht in Figur 1B dargestellt), beispielsweise um eine gewünschte Beweglichkeit von erzeugten mikroelektromechanischen Strukturen herzustellen. Ein solches Entfernen kann beispielsweise mittels Gasphasenätzen, Plasmaätzen oder Nassätzen erfolgen.

Wie in der oberen Teilfigur der Fig. 1B gezeigt (Seitenansicht, mit S gekennzeichnet), können durch eine geeignete Strukturierung der Siliziumschichten 150 elektrische Verbindungen 190 ausgeprägt werden. Diese elektrischen Verbindungen 190 können spezialisierte Funktionsbereiche 152 umfassen. Konkret gezeigt ist in Fig. 1B eine elektrische Verbindung 190 (veranschaulicht als mehrere Pfeile, die eine Stromrichtung der elektrischen Verbindung 190 symbolisieren), die sich von einem ersten elektrischen Element 194, das außerhalb des Siliziumschichtsystems 100 platziert ist, zu einem zweiten elektrischen Element 192 innerhalb des Siliziumschichtsystems 100 erstreckt. Dabei umfasst diese elektrische Verbindung 190 mehrere Abschnitte, in denen der Strom vertikal geführt wird, und mehrere Abschnitte, in denen er horizontal geführt wird, jeweils bezogen auf die Oberfläche 120 des mittlerweile entfernen Trägersubstrats 110. Genauer sind fünf für die elektrische Stromführung spezialisierte Funktionsbereiche 152v Teil von drei vertikal verlaufenden elektrischen Verbindungen 190v, und drei für die elektrische Stromführung spezialisierte Funktionsbereiche 152h sind Teil dreier horizontal verlaufender elektrischer Verbindungen 190h. Die spezialisierten Funktionsbereiche 152 stehen hierbei über die befüllten Ausnehmungen 191 in elektrischem Kontakt. Zusammen ergeben diese spezialisierten Funktionsbereiche 152 die elektrische Verbindung 190 zwischen dem externen Element 194 und dem internen Element 192, wobei es sich bei dem externen Element 194 beispielsweise um eine Steuerelektronik 198 mit einem Anschlussdraht 196 handeln kann. Auch der Anschlussdraht 196 selbst stellt hierbei ein externes Element im Sinne der Erfindung dar. In dem gezeigten Beispiel wurde zum Anschluss des externen Elements 194 die Isolationsschicht 122 an einer Stelle entfernt (Ausnehmung 126). Die Stromrichtung ist durch die Pfeilform des Anschlussdrahtes 196 des elektrischen Elements 194 symbolisiert. Das interne Element 192, das in Figur 1B zur besseren Kenntlichmachung durch eine andere Schraffierung zeichnerisch hervorgehoben wurde, kann beispielsweise ein Sensor, eine Elektrode und/oder ein Aktor sein, der mittels einer oder mehrerer Funktionsbereiche 152 des Siliziumschichtsystems 100 umgesetzt wurde. Der besseren Übersichtlichkeit halber wurde für die Figur 1B nur die elektrische Verbindung 190 für die Stromrichtung hin zum internen Element 192 gezeigt, auf eine Darstellung eines vollständigen Stromkreises wurde verzichtet. Es sei darauf hingewiesen, dass das interne Element 192 in der Figur 1B zwar in der zuäußerst liegenden ersten Siliziumschicht 150a angeordnet dargestellt ist, dies aber hier rein der Veranschaulichung der Möglichkeit komplexerer elektrischer Verbindungen 190 dient und in der Praxis typischerweise nicht der Fall ist. Die Erfindung ist nämlich dann besonders vorteilhaft einsetzbar, wenn kein einfacher, direkter Zugang zu einem internen Element 192 möglich ist (wie es hier über die Isolationsschicht 122 der Fall wäre), das an eine elektrische Verbindung 190 zu koppelnde interne Element 192 also weiter im Inneren eines herzustellenden Siliziumschichtsystems 100 liegt.

In der obersten Siliziumschicht 150e befindet sich hierbei ein spezialisierter Funktionsbereich 152h, der in der oberen Teilfigur S nur als zwei Teilbereiche 152h' und 152h" dargestellt ist. In der unteren Teilfigur T ist ein Schnitt durch die oberste Siliziumschicht 150e dargestellt, dessen Verlauf in der oberen Teilfigur S durch eine gestrichelte Linie markiert ist. Wie dargestellt, müssen die elektrischen Verbindungen 190 und deren spezialisierten Funktionsbereiche 152 nicht geradlinig verlaufen, sondern können jede beliebige Form annehmen. Zur Verdeutlichung ist in der unteren Teilfigur eine gestrichelte Linie S eingezeichnet, die die Lage der in der Teilfigur S gezeigten Ebene verdeutlicht.

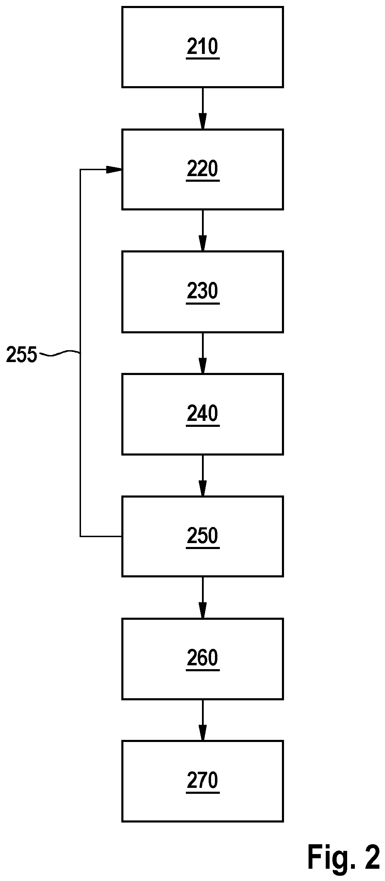

Figur 2 zeigt ein schematisches Flussdiagramm zur Erläuterung eines beispielhaften erfindungsgemäßen Verfahrens zur Herstellung eines Siliziumschichtsystems 100 mit elektrischen Verbindungen 190. Nach einem Bereitstellen 210 eines Trägersubstrats 110 wird eine erste Siliziumschicht 150a auf eine Oberfläche 120 dieses Trägersubstrats 110 aufgebracht, beispielsweise epitaktisch aufgewachsen. Anschließend erfolgt ein Strukturieren 230 dieser ersten Siliziumschicht 150a mittels Ausbilden von Gräben 156, die sich zumindest stellenweise durch die erste Siliziumschicht 150a erstrecken. Nach einem Passivieren 240 der ersten Siliziumschicht 150a, das mit einem Befüllen der Gräben 156 einhergeht, bildet sich auch außerhalb der Gräben 156 eine erste Passivierungsschicht 154a. Diese befindet sich auf der der Isolationsschicht 122 abgewandten Seite der ersten Siliziumschicht 150a. Die so erzeugte erste Passivierungsschicht 154a wird nun in Schritt 250 strukturiert, um Funktionsbereiche 152 und Opferbereiche 153 zu definieren. Diese Schritte zum Ausbilden von strukturierten aufgebrachten Siliziumschichten 150 können nun beliebig häufig wiederholt werden. Dies ist durch Pfeil 255 versinnbildlicht.

Hierbei werden die Schritte 220 bis 250 jeweils so ausgeführt werden, dass eine elektrische Verbindung 190 umfassend mindestens einen spezialisierten Funktionsbereich 152h, 152v ausgeprägt wird, durch die eine elektrische Verbindung zwischen zwei Elementen 192, 194 innerhalb und/oder außerhalb des Siliziumschichtsystems 100 herstellbar ist, wobei der mindestens eine spezialisierte Funktionsbereich 152h, 152v allein der elektrischen Verbindung 190 dient.

Sobald alle gewünschten Siliziumschichten 150 aufgebracht, wird das Trägersubstrat 110 entfernt (Schritt 260) und anschließend die Opferbereiche 153 mittels eines Verfahrens zum Siliziumopferschichtätzen in Schritt 270 entfernt. Optional kann auch noch ein Gasphasenätzen, Plasmaätzen und/oder Nassätzen erfolgen, um die Passivierungsschichten 154 zumindest teilweise zu entfernen.

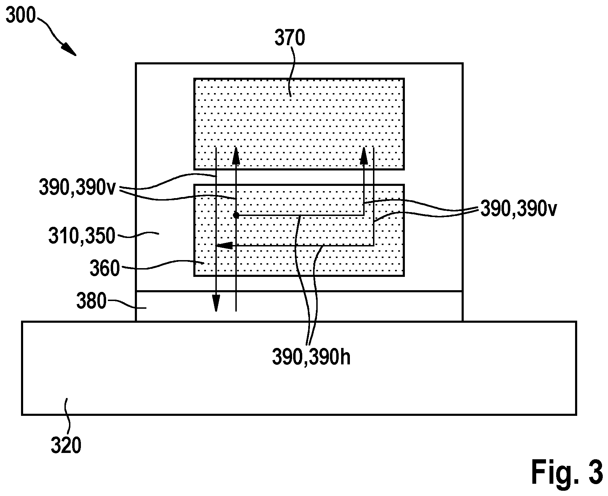

Figur 3 zeigt in schematischer Darstellung eine beispielhafte erfindungsgemäße mikroelektromechanische Vorrichtung 300, beispielsweise ein MEMS. Die mikroelektromechanische Vorrichtung 300 weist ein Siliziumschichtsystem 310 auf, das nach einem erfindungsgemäßen Verfahren hergestellt wurde. Dieses Siliziumschichtsystem 310 umfasst eine alternierende Abfolge 350 von strukturierten Siliziumschichten 150 mit Funktionsbereichen 152 und strukturierten Passivierungsschichten 154. Weiterhin sind im Siliziumschichtsystem 310 elektrische Verbindungen 390 ausgeprägt, die aus spezialisierten Funktionsbereichen 152h, 152v der Siliziumschichten 150 bestehen, wobei durch die elektrischen Verbindungen 390 ein elektrischer Kontakt zwischen einem internen Element 370, beispielsweise einem Aktor, der durch Funktionsbereiche 152 des Siliziumschichtsystems 310 realisiert ist, und einem externen Element 380, beispielsweise einer Steuerelektronik 198 mit Anschlussdraht 196, hergestellt wird. Hierbei dienen die spezialisierten Funktionsbereiche 152h, 152v allein der elektrischen Verbindung 390.

Im dargestellten Beispiel umfassen die elektrischen Verbindungen 390 vertikal verlaufende elektrische Verbindungen 390v und horizontal verlaufende elektrische Verbindungen 390h. Mittels des Siliziumschichtsystems 310 kann beispielsweise auch eine Verschaltung 360 umfassend eine Vielzahl von elektrischen Verbindungen 390 realisiert sein. Die mikroelektromechanische Vorrichtung 300 befindet sich auf einem Träger 320, der beispielsweise weitere elektrische und elektronische Komponenten umfassen kann, die der Ansteuerung der mikroelektromechanischen Vorrichtung 310 dienen.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zur Herstellung eines Siliziumschichtsystems (100, 310) mit elektrischen Verbindungen (190, 390) mit den Schritten:
a. Bereitstellen (210) eines Trägersubstrats (110) mit einer Oberfläche (120), wobei das Trägersubstrat (110) mit einer auf der Oberfläche (120) ausgebildeten Isolationsschicht (122) versehen ist;
b. Aufbringen (220) einer ersten Siliziumschicht (150a) auf die Isolationsschicht (122);
c. Strukturieren (230) der ersten Siliziumschicht (150a) zum Ausbilden von Gräben (156) in der ersten Siliziumschicht (150a), wobei sich die Gräben (156) zumindest stellenweise durch die erste Siliziumschicht (150a) erstrecken;
d. Passivieren (240) der ersten Siliziumschicht (150a), wobei die Gräben (156) befüllt werden und sich auf einer der Isolationsschicht (122) abgewandten Seite der ersten Siliziumschicht (150a) eine erste Passivierungsschicht (154a) bildet;
e. Strukturieren (250) der ersten Passivierungsschicht (154a), wobei sich in der ersten Siliziumschicht (150a) erste Opferbereiche (153) und Funktionsbereiche (152) ausbilden und die ersten Opferbereiche (153) auf der der Isolationsschicht (122) abgewandten Seite der ersten Siliziumschicht (150a) zumindest stellenweise frei von der ersten Passivierungsschicht (154a) sind;
f. ein- oder mehrmaliges Wiederholen (255) der Schritte b bis e, wobei das Aufbringen (220) jeweils auf eine strukturierte Passivierungsschicht (154) erfolgt und wodurch weitere Siliziumschichten (150b, 150c, 150d, 150e) und weitere Passivierungsschichten (154b, 154c, 154d, 154e) ausgebildet und strukturiert werden, wodurch weitere Opferbereiche (153) und weitere Funktionsbereiche (152) in den weiteren Siliziumschichten (150b, 150c, 150d, 150e) entstehen; und
g. Entfernen (270) aller Opferbereiche (153) nach dem ein- oder mehrmaligen Wiederholen (255) der Schritte b bis e,
wobei die Schritte b bis f so ausgeführt werden, dass eine elektrische Verbindung (190, 390) umfassend mindestens einen spezialisierten Funktionsbereich (152h, 152v) ausgeprägt wird, durch die ein elektrischer Kontakt zwischen zwei Elementen (192, 194, 196, 370, 380) innerhalb und/oder außerhalb des Siliziumschichtsystems (100, 310) herstellbar ist, wobei der mindestens eine spezialisierte Funktionsbereich (152h, 152v) allein der elektrischen Verbindung (190, 390) dient.

2. Verfahren nach Anspruch 1, wobei die elektrische Verbindung (190, 390)
∘ eine vertikal verlaufende elektrische Verbindung (190v, 390v) ist oder umfasst, die aus mehreren übereinander angeordneten spezialisierten Funktionsbereichen (152v) der Funktionsbereiche (152) besteht oder diese umfasst, wobei die mehreren spezialisierten Funktionsbereiche (152v) allein der elektrischen Verbindung (190v, 390v) dienen; und/oder
∘ eine horizontal verlaufende elektrische Verbindung (190h, 390h) ist oder umfasst.

3. Verfahren nach Anspruch 1 oder 2, wobei eine der Passivierungsschichten (154) zumindest stellenweise aus einem ersten Material und eine der Passivierungsschichten (154) und/oder die Isolationsschicht (122) zumindest stellenweise aus einem zweiten Material besteht.

4. Verfahren nach einem der vorhergehenden Ansprüche, wobei ein Entfernen (260) des Trägersubstrats (110) erfolgt, das vorzugsweise vor dem Entfernen (270) der Opferbereiche (153) und/oder mittels eines chemisch-mechanischen Polierens durchgeführt wird.

5. Verfahren nach einem der vorhergehenden Ansprüche, **dadurch gekennzeichnet, dass** das Strukturieren (250) der Passivierungsschichten (154) durch ein Trockenätzverfahren und/oder ein Nassätzverfahren erfolgt.

6. Verfahren nach einem der vorhergehenden Ansprüche, wobei nach dem Aufbringen (220) einer der Siliziumschichten (150) ein chemisch-mechanisches Polieren und/oder zumindest stellenweise eine zusätzliche Dotierung durch Implantation und/oder Belegung dieser Siliziumschicht (150) erfolgt.

7. Verfahren nach einem der vorhergehenden Ansprüche, wobei das Entfernen (270) von Opferbereichen (153) zumindest teilweise durch plasmaloses und/oder plasmaunterstütztes Ätzen erfolgt.

8. Siliziumschichtsystem (100, 310), vorzugsweise hergestellt nach einem Verfahren nach einem der Ansprüche 1 bis 7, aufweisend eine alternierende Abfolge (350) von strukturierten Siliziumschichten (150) mit Funktionsbereichen (152) und strukturierten Passivierungsschichten (154) und eine elektrische Verbindung (190, 390) bestehend aus einem oder mehreren spezialisierten Funktionsbereichen (152h, 152v) der Funktionsbereiche (152),
wobei durch die elektrische Verbindung (190, 390) ein elektrischer Kontakt zwischen zwei Elementen (192, 194, 370, 380) innerhalb und/oder außerhalb des Siliziumschichtsystems (100, 310) herstellbar ist, wobei der eine oder die mehreren spezialisierten Funktionsbereiche (152h, 152v) allein der elektrischen Verbindung (190, 390) dienen.

9. Siliziumschichtsystem (100, 310) nach Anspruch 8, wobei die elektrische Verbindung (190, 390)
a. eine vertikal verlaufende elektrische Verbindung (190v, 390v) ist oder umfasst, die aus mehreren übereinander angeordneten spezialisierten Funktionsbereichen (152h, 152v) der Funktionsbereiche (152) besteht oder diese umfasst, wobei die mehreren spezialisierten Funktionsbereiche (152h, 152v) allein der elektrischen Verbindung (190, 390) dienen; und/oder
b. eine horizontal verlaufende elektrische Verbindung (190h, 390h) ist oder umfasst.

10. Mikroelektromechanische Vorrichtung (300) aufweisend ein Siliziumschichtsystem (100, 310) nach Anspruch 8 oder 9.

## Claims

1. Method of producing a silicon layer system (100, 310) having electrical connections (190, 390), comprising the steps of:
a. providing (210) a carrier substrate (110) having a surface (120), where the carrier substrate (110) has been provided with an insulation layer (122) formed on the surface (120);
b. applying (220) a first silicon layer (150a) to the insulation layer (122);
c. structuring (230) the first silicon layer (150a) to form trenches (156) in the first silicon layer (150a), where the trenches (156) extend through the first silicon layer (150a) at least in places;
d. passivating (240) the first silicon layer (150a), wherein the trenches (156) are filled and a first passivation layer (154a) is formed on a side of the first silicon layer (150a) which is remote from the insulation layer (122);
e. structuring (250) the first passivation layer (154a), forming first sacrificial regions (153) and functional regions (152) in the first silicon layer (150a), where the first sacrificial regions (153) on the side of the first silicon layer (150a) which is remote from the insulation layer (122) are free of the first passivation layer (154a) at least in places;
f. repeating (255) steps b to e once or more than once, where the applying (220) is to a structured passivation layer (154) in each case, as a result of which further silicon layers (150b, 150c, 150d, 150e) and further passivation layers (154b, 154c, 154d, 154e) are formed and structured, which gives rise to further sacrificial regions (153) and further functional regions (152) in the further silicon layers (150b, 150c, 150d, 150e); and
g. removing (270) all sacrificial regions (153) after steps b to e have been repeated (255) once or more than once,
wherein steps b to f are executed such that an electrical connection (190, 390) comprising at least one specialized functional region (152h, 152v) is formed, by means of which an electrical contact between two elements (192, 194, 196, 370, 380) can be established within and/or outside the silicon layer system (100, 310), where the at least one specialized functional region (152h, 152v) serves solely for electrical connection (190, 390).

2. Method according to Claim 1, wherein the electrical connection (190, 390)
∘ is or comprises a vertical electrical connection (190v, 390v) consisting of or comprising two or more mutually superposed specialized functional regions (152v) of the functional regions (152), where the two or more specialized functional regions (152v) serve solely for electrical connection (190v, 390v); and/or
∘ is or comprises a horizontal electrical connection (190h, 390h).

3. Method according to Claim 1 or 2, wherein one of the passivation layers (154) consists at least partly of a first material and one of the passivation layers (154) and/or the insulation layer (122) consists at least partly of a second material.

4. Method according to any of the preceding claims, wherein the carrier substrate (110) is removed (260), and this is preferably conducted prior to the removing (270) of the sacrificial regions (153) and/or by means of a chemo-mechanical polishing operation.

5. Method according to any of the preceding claims, **characterized in that** the passivation layers (154) are structured (250) by a dry etching method and/or a wet etching method.

6. Method according to any of the preceding claims, wherein the applying (220) of one of the silicon layers (150) is followed by chemo-mechanical polishing and/or, at least in places, by additional doping by implantation and/or coverage of said silicon layer (150).

7. Method according to any of the preceding claims, wherein sacrificial regions (153) are removed (270) at least partly by plasma-free and/or plasma-assisted etching.

8. Silicon layer system (100, 310), preferably produced by a method according to any of Claims 1 to 7, having an alternating sequence (350) of structured silicon layers (150) with functional regions (152) and structured passivation layers (154) and an electrical connection (190, 390) consisting of one or more specialized functional regions (152h, 152v) of the functional regions (152), wherein the electrical connection (190, 390) can establish an electrical contact between two elements (192, 194, 370, 380) within and/or outside the silicon layer system (100, 310), wherein the one or more specialized functional regions (152h, 152v) serve solely for electrical connection (190, 390).

9. Silicon layer system (100, 310) according to Claim 8, wherein the electrical connection (190, 390)
a. is or comprises a vertical electrical connection (190v, 390v) consisting of or comprising two or more mutually superposed specialized functional regions (152h, 152v) of the functional regions (152), where the two or more specialized functional regions (152h, 152v) serve solely for electrical connection (190, 390); and/or
b. is or comprises a horizontal electrical connection (190h, 390h).

10. Microelectromechanical device (300) comprising a silicon layer system (100, 310) according to Claim 8 or 9.

## Revendications

1. Procédé de fabrication d'un système de couches de silicium (100, 310) avec des connexions électriques (190, 390), avec les étapes de :
a. fourniture (210) d'un substrat porteur (110) avec une surface (120), le substrat porteur (110) étant pourvu d'une couche isolante (122) formée sur la surface (120) ;
b. application (220) d'une première couche de silicium (150a) sur la couche isolante (122) ;
c. structuration (230) de la première couche de silicium (150a) pour former des tranchées (156) dans la première couche de silicium (150a), les tranchées (156) s'étendant au moins par endroits à travers la première couche de silicium (150a) ;
d. passivation (240) de la première couche de silicium (150a), les tranchées (156) étant remplies et une première couche de passivation (154a) se formant sur un côté de la première couche de silicium (150a) opposé à la couche isolante (122) ;
e. structuration (250) de la première couche de passivation (154a), des premières zones sacrificielles (153) et des zones fonctionnelles (152) se formant dans la première couche de silicium (150a) et les premières zones sacrificielles (153) étant exemptes de la première couche de passivation (154a) au moins par endroits sur le côté de la première couche de silicium (150a) opposé à la couche isolante (122) ;
f. répétition (255) des étapes b à e une ou plusieurs fois, l'application (220) étant effectuée dans chaque cas sur une couche de passivation structurée (154) et d'autres couches de silicium (150b, 150c, 150d, 150e) et d'autres couches de passivation (154b, 154c, 154d, 154e) étant formées et structurées par la suite, ce qui permet de produire d'autres zones sacrificielles (153) et d'autres zones fonctionnelles (152) dans les autres couches de silicium (150b, 150c, 150d, 150e) ; et
g. retrait (270) de toutes les zones sacrificielles (153) après avoir répété (255) les étapes b à e une ou plusieurs fois,
les étapes b à f étant exécutées de telle sorte qu'une connexion électrique (190, 390) comprenant au moins une zone fonctionnelle spécialisée (152h, 152v) apparaît, laquelle permet d'établir un contact électrique entre deux éléments (192, 194, 196, 370, 380) à l'intérieur et/ou à l'extérieur du système de couches de silicium (100, 310), l'au moins une zone fonctionnelle spécialisée (152h, 152v) servant uniquement à la connexion électrique (190, 390).

2. Procédé selon la revendication 1, la connexion électrique (190, 390)
∘ étant ou comprenant une connexion électrique s'étendant verticalement (190v, 390v), qui est constituée de plusieurs zones fonctionnelles spécialisées (152v) des zones fonctionnelles (152) disposées les unes au-dessus des autres ou comprend celles-ci, les plusieurs zones fonctionnelles spécialisées (152v) servant uniquement à la connexion électrique (190v, 390v) ; et/ou
∘ étant ou comprenant une connexion électrique s'étendant horizontalement (190h, 390h).

3. Procédé selon la revendication 1 ou 2, l'une des couches de passivation (154) étant constituée au moins par endroits d'un premier matériau et l'une des couches de passivation (154) et/ou la couche d'isolation (122) étant constituées au moins par endroits d'un deuxième matériau.

4. Procédé selon l'une des revendications précédentes, le substrat porteur (110) étant retiré (260), qui est effectué de préférence avant le retrait (270) des zones sacrificielles (153) et/ou au moyen d'un polissage chimico-mécanique.

5. Procédé selon l'une des revendications précédentes, **caractérisé en ce que** la structuration (250) des couches de passivation (154) est effectuée par un procédé de gravure sèche et/ou par un procédé de gravure humide.

6. Procédé selon l'une des revendications précédentes, **caractérisé en ce que**, après l'application (220) de l'une des couches de silicium (150), un polissage chimico-mécanique et/ou au moins par endroits un dopage supplémentaire sont effectués par implantation et/ou occupation de ladite couche de silicium (150).

7. Procédé selon l'une des revendications précédentes, **caractérisé en ce que** le retrait (270) de zones sacrificielles (153) est effectué au moins en partie par gravure sans plasma et/ou assistée par plasma.

8. Système de couches de silicium (100, 310), fabriqué de préférence par un procédé selon l'une des revendications 1 à 7, comportant une succession alternée (350) de couches de silicium (150) structurées avec des zones fonctionnelles (152) et des couches de passivation (154) structurées et une connexion électrique (190, 390) constituée d'une ou de plusieurs zones fonctionnelles spécialisées (152h, 152v) des zones fonctionnelles (152),
la connexion électrique (190, 390) permettant d'établir un contact électrique entre deux éléments (192, 194, 370, 380) à l'intérieur et/ou à l'extérieur du système de couches de silicium (100, 310), la ou les plusieurs zones fonctionnelles spécialisées (152h, 152v) servant uniquement à la connexion électrique (190, 390).

9. Système de couches de silicium (100, 310) selon la revendication 8, la connexion électrique (190, 390)
a. étant ou comprenant une connexion électrique s'étendant verticalement (190v, 390v), qui est constituée de plusieurs zones fonctionnelles spécialisées (152h, 152V) des zones fonctionnelles (152) disposées les unes au-dessus des autres ou comprend celles-ci, les plusieurs zones fonctionnelles spécialisées (152h, 152v) servant uniquement à la connexion électrique (190, 390) ; et/ou
b. étant ou comprenant une connexion électrique s'étendant horizontalement (190h, 390h).

10. Dispositif microélectromécanique (300) comportant un système de couches de silicium (100, 310) selon la revendication 8 ou 9.
